# EUROPEAN PATENT APPLICATION

(11) **EP 2 206 756 A1**
(43) Date of publication of application: **14.07.2010**
(21) Application number: 08845115.8
(22) Date of filing: 29.08.2008
(51) Int. Cl.: C09J 4/00, C09J 11/06, H01B 1/22, H01L 21/60, H01R 43/00, H05K 1/14, H05K 3/32

(54) **CIRCUIT CONNECTING MATERIAL, CONNECTION STRUCTURE AND METHOD FOR PRODUCING THE SAME**

(30) Priority: 29.10.2007 JP 2007280224
(71) Applicant: Hitachi Chemical Company, Ltd., Tokyo 163-0449 (JP)
(72) Inventor: NAKAZAWA, Takashi, Chikusei-shi Ibaraki 308-8524 (JP); ARIFUKU, Motohiro, Chikusei-shi Ibaraki 308-8524 (JP); KOJIMA, Kazuyoshi, Chikusei-shi Ibaraki 308-8524 (JP); MOCHIZUKI, Nichiomi, Chikusei-shi Ibaraki 308-8524 (JP)
(74) Representative: HOFFMANN EITLE
(86) International application number: PCT/JP2008/065555
(87) International publication number: WO 2009/057376

(57) **Abstract**

The circuit connecting material of the invention is a circuit connecting material for connection between a first circuit member having a first circuit electrode formed on the main side of a first board, and a second circuit member having a second circuit electrode formed on the main side of a second board, with the first circuit electrode and second circuit electrode laid facing each other, the circuit connecting material comprising a curing agent that generates free radicals, a radical polymerizing substance and a compound containing secondary thiol group. The circuit connecting material of the invention is capable of low-temperature rapid curing and has excellent storage stability.

## Description

### Technical Field

The present invention relates to a circuit connecting material that, when it is situated between opposing circuit electrodes and the opposing circuit electrodes are pressed, accomplishes electrical connection between the electrodes in the pressing direction, as well as to a connection structure employing the circuit connecting material and a method for producing the same.

### Background Art

Thermosetting resins employing epoxy resins, which have high adhesion and high reliability, are known as circuit connecting materials for semiconductor elements and liquid crystal display units (for example, see Patent document 1). The constituent components of such resins generally include an epoxy resin, a curing agent such as a phenol resin which is reactive with the epoxy resin, and a latent curing agent that promotes reaction between the epoxy resin and curing agent. The latent curing agent is an important element determining the curing temperature and curing speed, and various compounds are selected from the viewpoint of their storage stability at room temperature and the curing speed with heating.

Radical curing adhesives, which employ acrylate derivatives and methacrylate derivatives (hereinafter referred to collectively as "(meth)acrylate derivatives") together with peroxides as radical polymerization initiators, have been the object of much interest in recent years. Radical curing can accomplish rapid curing due to the high reactivity of radical reactive species (see Patent documents 2 and 3, for example).

Rapid-curing adhesives that are useful for shortening production time are therefore becoming more popular. Application of chain transfer agents is also being studied for the purpose of further improving the reactivity of radical curing adhesives (see Patent document 4, for example). Using chain transfer agents is expected to provide fast-curing effects, while also improving low-temperature rapid connection and adhesive force on inorganic materials such as metals.
[Patent document 1] Japanese Unexamined Patent Publication HEI No. 1-113480
[Patent document 2] Japanese Unexamined Patent Publication No. 2002-203427
[Patent document 3] International Patent Publication No. WO98/044067
[Patent document 4] Japanese Unexamined Patent Publication No. 2003-221557

### Disclosure of the Invention

### Problems to be Solved by the Invention

It is an object of the present invention to provide a circuit connecting material that allows the aforementioned advantages of chain transfer agents, namely rapid curing, low-temperature rapid connection and improved adhesion with organic substances such as metals, to be effectively obtained, as well as a connection structure employing the circuit connecting material and a method for producing the same.

### Means for Solving the Problems

As a result of much diligent research with the aim of achieving this object, the present inventors have found that an adhesive force-improving effect and prolonged storage stability can be achieved by using a compound with a secondary thiol group as the chain transfer agent, and the present invention has been completed based on this finding.

Specifically, the invention provides a circuit connecting material for connection between a first circuit member having a first circuit electrode formed on the main side of a first board, and a second circuit member having a second circuit electrode formed on the main side of a second board, with the first circuit electrode and second circuit electrode laid facing each other, the circuit connecting material comprising a curing agent that generates free radicals, a radical polymerizing substance and a compound containing secondary thiol group.

The molecular weight of the compound containing secondary thiol group in the circuit connecting material of the invention is preferably 400 or greater.

The invention further provides a connection structure which comprises a first circuit member having a first circuit electrode formed on the main side of a first board, a second circuit member having a second circuit electrode formed on the main side of a second board and situated so that the second circuit electrode and first circuit electrode are facing each other, and an adhesive layer provided between the first circuit member and second circuit member and electrically connecting the first circuit member and second circuit member, wherein the adhesive layer is formed by placing the circuit connecting material of the invention between the first circuit member and second circuit member and pressing them.

The invention still further provides a method for producing a connection structure, which includes a step of situating a first circuit member having a first circuit electrode formed on the main side of a first board and a second circuit member having a second circuit electrode formed on the main side of a second board, in such a manner that the first circuit electrode and second circuit electrode are facing each other, placing the circuit connecting material of the invention between the first circuit member and second circuit member, and pressing them in that state for electrical connection between the first circuit electrode and second circuit electrode.

### Effect of the Invention

According to the invention there is provided a circuit connecting material capable of low temperature rapid curing and exhibiting excellent storage stability, as well as a connection structure employing the circuit connecting material and a method for producing the same.

### Brief Description of the Drawings

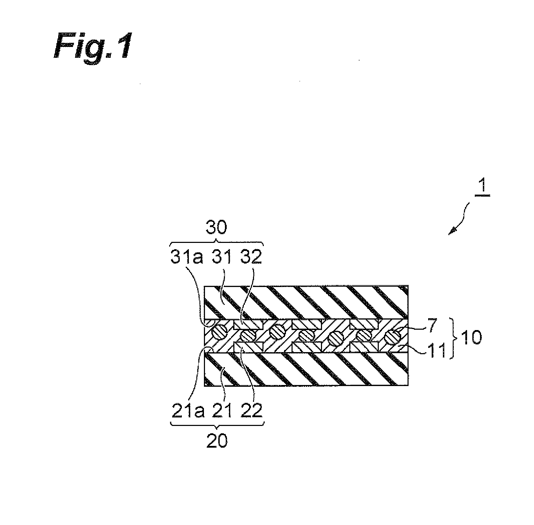

Fig. 1 is a schematic cross-sectional view showing an embodiment of a connection structure.

### Explanation of Symbols

1: Connection structure, 7: conductive particles, 10: adhesive layer, 11: insulating layer, 20: first circuit member, 21: first circuit board, 22: first circuit electrode (first connecting terminal), 30: second circuit member, 31: second circuit board, 32: second circuit electrode (second connecting terminal).

### Best Modes for Carrying Out the Invention

Preferred embodiments of the invention will now be described in detail.

The circuit connecting material of the invention is a circuit connecting material for connection between a first circuit member having a first circuit electrode formed on the main side of a first board, and a second circuit member having a second circuit electrode formed on the main side of a second board, with the first circuit electrode and second circuit electrode laid facing each other, the circuit connecting material comprising a curing agent that generates free radicals, a radical polymerizing substance and a compound containing secondary thiol group.

The curing agent that generates free radicals for use according to the invention is preferably one that generates free radicals by decomposition of a peroxide compound, azo-based compound or the like by heating, and it may be appropriately selected based on the desired connection temperature and connection time. The content is preferably about 0.05-10 wt% and more preferably 0.1-5 wt%. Specifically, it may be selected from among diacyl peroxides, peroxy dicarbonates, peroxy esters, peroxy ketals, dialkyl peroxides, hydroperoxides and the like.

As diacyl peroxides there may be mentioned 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene and benzoyl peroxide.

As peroxy dicarbonates there may be mentioned di-n-propyl peroxydicarbonate, diisopropyl peroxydicarbonate, bis(4-t-butylcyclohexyl)peroxy dicarbonate, di-2-ethoxymethoxyperoxy dicarbonate, di(2-ethylhexylperoxy)dicarbonate, dimethoxybutyl peroxydicarbonate and di(3-methyl-3-methoxybutylperoxy)dicarbonate.

As peroxy esters there may be mentioned 1,1,3,3-tetramethylbutyl peroxyneodecanoate, 1-cyclohexyl-1-methylethyl peroxyneodecanoate, t-hexyl peroxyneodecanoate, t-butyl peroxypivalate, 1,1,3,3-tetramethylbutylperoxy-2-ethyl hexanonate, 2,5-dimethyl-2,5-di(2-ethylhexanoylperoxy)hexane, 1-cyclohexyl-1-methylethylperoxy-2-ethyl hexanonate, t-hexylperoxy-2-ethyl hexanonate, t-butylperoxy-2-ethyl hexanonate, t-butyl peroxyisobutyrate, 1,1-bis(t-butylperoxy)cyclohexane, t-hexylperoxyisopropyl monocarbonate, t-butylperoxy-3,5,5-trimethyl hexanonate, t-butyl peroxylaurate, 2,5-dimethyl-2,5-di(m-toluoylperoxy)hexane, t-butylperoxy isopropylmonocarbonate, t-butylperoxy-2-ethylhexyl monocarbonate, t-hexyl peroxybenzoate and t-butyl peroxyacetate.

As peroxy ketals there may be mentioned 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-(t-butylperoxy)cyclododecane and 2,2-bis(t-butylperoxy)decane.

As dialkyl peroxides there may be mentioned α,α'-bis(t-butylperoxy)diisopropylbenzene, dicumyl peroxide, 2,5-dimethyl-2,5-di(t-butylperoxy)hexane and t-butylcumyl peroxide.

As hydroperoxides there may be mentioned diisopropylbenzene hydroperoxide and cumene hydroperoxide.

These free radical generators may be used alone or in combinations of two or more, and may also be used in admixture with triggers or inhibitors. From the viewpoint of extending the storage life, these curing agents are preferably used in a microencapsulated form by coating with a polyurethane-based or polyester-based macromolecular compound.

The radical-polymerizing substance for the invention may be used as a monomer or oligomer, or a monomer and oligomer may be used in combination. As specific examples of radical-polymerizing substances there may be mentioned ethyleneglycol diacrylate, diethyleneglycol diacrylate, trimethylolpropane triacrylate, tetramethylolmethane tetraacrylate, 2-hydroxy-1,3-diacryloxypropane, 2,2-bis[4-(acryloxymethoxy)phenyl]propane, 2,2-bis[4-(acryloxypolyethoxy)phenyl]propane, dicyclopentenyl acrylate, tricyclodecanyl acrylate and tris(acryloyloxyethyl)isocyanurate. These may be used alone or in mixtures of two or more. If necessary, an appropriate amount of a polymerization inhibitor such as hydroquinone or methyl ether hydroquinone may be used. They preferably have dicyclopentenyl and/or tricyclodecanyl and/or triazine rings for improved heat resistance.

Including a polymer such as polystyrene, polyethylene, polyvinyl butyral, polyvinyl formal, polyimide, polyamide, polyester, polyvinyl chloride, polyphenylene oxide, urea resin, melamine resin, phenol resin, xylene resin, epoxy resin, polyisocyanate resin or phenoxy resin in the radical-polymerizing substance is preferred for superior handleability and stress relaxation during curing, and the polymer preferably has a functional group such as hydroxyl for further improved adhesion. Each polymer is preferably one modified by a radical-polymerizing functional group. The weight-average molecular weight of the polymer is preferably 10,000 or greater, and more preferably between 10,000 and 1,000,000 from the viewpoint of miscibility. Throughout the present specification, the weight-average molecular weight is the value measured by gel permeation chromatography (GPC) under the following conditions, using a standard polystyrene calibration curve.

### [GPC conditions]

Apparatus: Hitachi L-6000 [Hitachi, Ltd.], Column: gel pack GL-R420 + gel pack GL-R430 + gel pack GL-R440 (total: 3) [trade name of Hitachi Chemical Co., Ltd.], Eluent: tetrahydrofuran, Measuring temperature: 40°C, Flow rate: 1.75 ml/min, Detector: L-3300RI [Hitachi, Ltd.].

The radical-polymerizing substance may further contain a filler, softening agent, accelerator, age inhibitor, coloring agent, flame retardant, thixotropic agent, coupling agent, phenol resin, melamine resin, isocyanate or the like. A filler is preferably included to improve the connection reliability. The filler used may be any one with a maximum diameter of less than the particle size of the conductive particles, and it is preferably used in a range of 5-60 vol%. The effect of improved reliability becomes saturated at 60 vol% or greater. Preferred coupling agents, from the viewpoint of adhesion, are compounds containing one or more groups selected from among vinyl, acrylic, amino, epoxy and isocyanate groups.

The compound containing secondary thiol group used for the invention is preferably a compound represented by any of the following formulas (1)-(5).

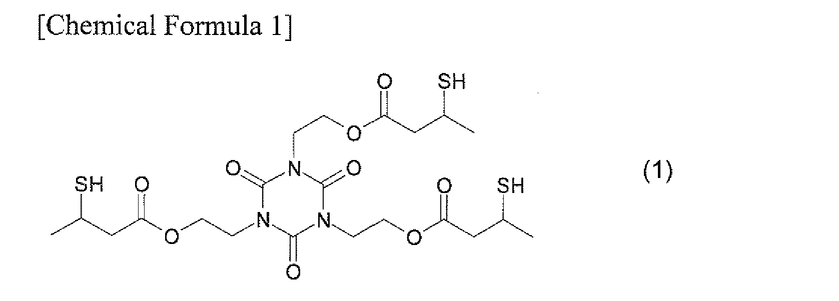

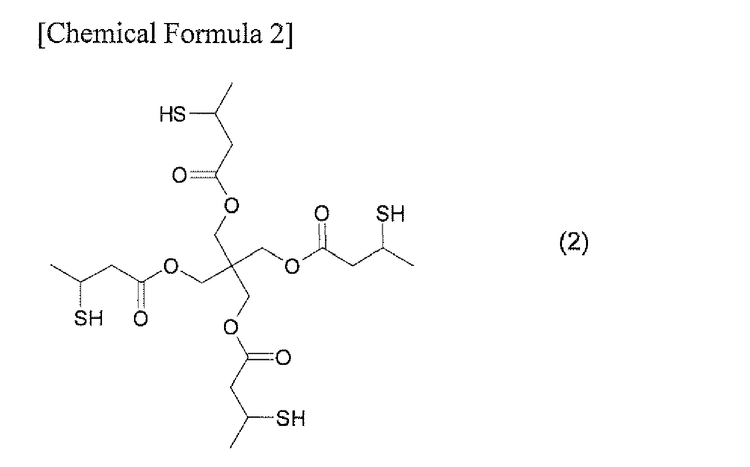

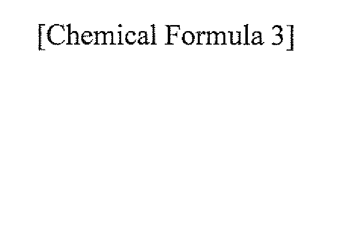

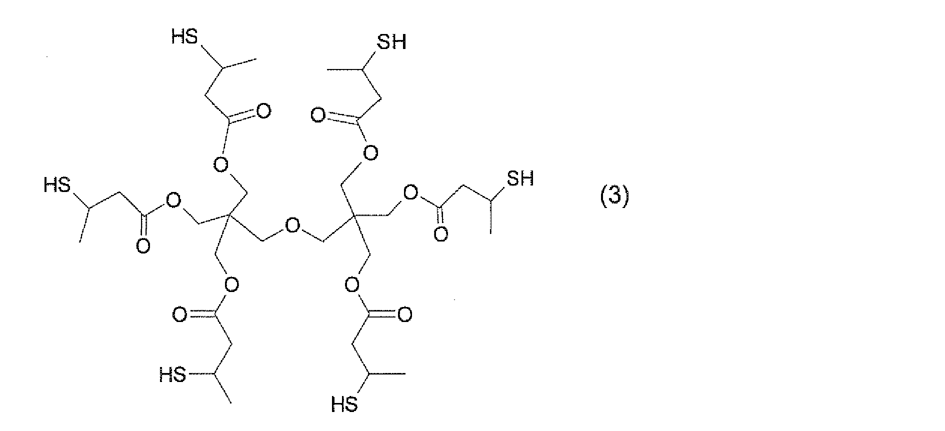

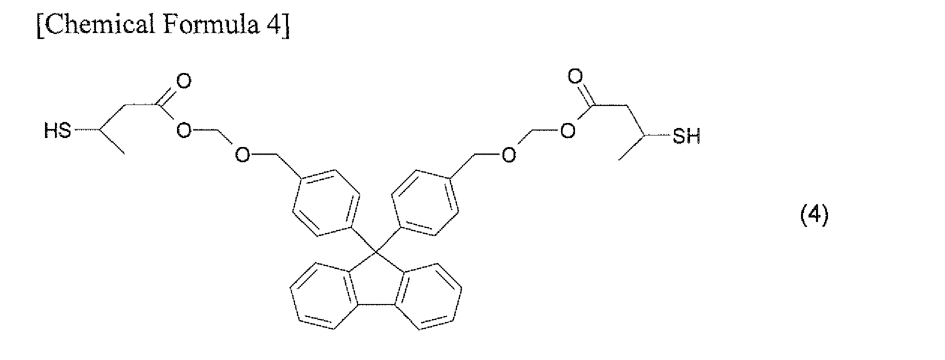

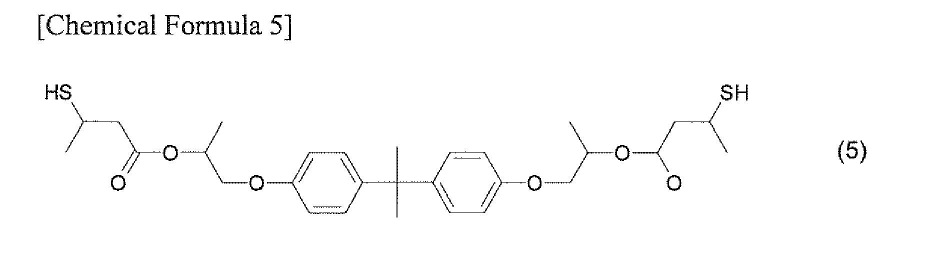

As preferred examples of compounds containing secondary thiol group there may be mentioned allylbenzenethiol sulfonates, benzenethiol, o-ethoxybenzenethiol, p-ethoxybenzenethiol, 2-benzimidazolethiol, o-mercaptobenzoic acid, o-mercaptomethyl benzoate ester, 2-benzothiazolethiol, secondary butanethiols, 2,3-butanedithiol, hex-5-ene-3-thiol, secondary dodecanethiols, secondary heptanethiols, secondary hexanethiols, naphthalenemethanethiol, mercaptobenzooxazole, naphthalenethiol, secondary octadecanethiols, secondary octanethiols, 2-methyl-2-propanethiol, toluenethiol, thiobisbenzenethiol, p-methoxy-toluenethiol and the like. Compounds containing secondary thiol group have higher reactivity as chain transfer agents compared to alcohols, and are therefore highly practical.

The molecular weight of the compound containing secondary thiol group is preferably at least 90 and less than 5000, and more preferably at least 150 and less than 2000. If the molecular weight is less than 90, the boiling point of the compound will be reached by heating during connection, thus causing evaporation and tending to impede a sufficient amount of compound containing secondary thiol group from contributing to the reaction. If the molecular weight is 5000 or greater, on the other hand, the resin elimination property will be impaired and the connection resistance may be increased.

The number of thiol equivalents of the compound containing secondary thiol group is preferably at least 50 and less than 500, and more preferably at least 120 and less than 400. With less than 50 thiol equivalents, the crosslink density will be reduced and the resistance reliability of the circuit connecting material will tend to be lower. With 500 or greater thiol equivalents, on the other hand, it will tend to be difficult to obtain an adhesive force-improving effect.

From the viewpoint of workability during production and handleability of the product, the molecular weight of the compound containing secondary thiol group is preferably 400 or greater. With a molecular weight of less than 400, the odor will be increased and workability and handleability will tend to be reduced, during formulation of the material and handling of the product. With a molecular weight of at least 400, odor will be inhibited and problems with workability and handleability will not result.

The amount of compound containing secondary thiol group added is preferably 1-20 parts by weight and more preferably 2-10 parts by weight with respect to 100 parts by weight of the radical-polymerizing substance. At less than 1 part by weight it will be difficult to obtain an adhesive force-improving effect, while at 20 parts by weight or greater the crosslink density will tend to be reduced and the resistance reliability of the circuit connecting material will tend to be impaired.

The circuit connecting material of the invention may consist entirely of a free radical-generating curing agent, a radical polymerizing substance and a compound containing secondary thiol group, but if necessary it may also contain the additional components mentioned below.

The circuit connecting material of the invention may further contain a compound with one or more aminoxyl structures in the molecule. If the circuit connecting material of the invention contains a compound with an aminoxyl structure, the storage stability of the circuit connecting material can be further improved.

The circuit connecting material of the invention may still further comprise a thermoplastic resin. Thermoplastic resins that may be used include polyvinyl butyral resins, polyvinyl formal resins, polyamide resins, polyester resins, phenol resins, epoxy resins, phenoxy resins, polystyrene resins, xylene resins and polyurethane resins. The weight-average molecular weight of these thermoplastic resins is preferably at least 10,000 from the viewpoint of film formability, while from the viewpoint of miscibility it is preferably between 10,000 and 1,000,000. The weight-average molecular weight of the thermoplastic resin is measured in the same manner as the polymerization average molecular weight of the polymer optionally included in the radical-polymerizing substance.

The thermoplastic resin is preferably a hydroxyl-containing resin (for example, a phenoxy resin) with a Tg (glass transition temperature) of 40°C or higher and a weight-average molecular weight of 10,000 or greater. A hydroxyl-containing resin may also be modified with an epoxy group-containing elastomer or radical-polymerizing functional group. Modification with a radical-polymerizing functional group is preferred for improved heat resistance.

A phenoxy resin can be obtained either by reacting a bifunctional phenol with an epihalohydrin to a high molecular weight, or by polyaddition of a bifunctional epoxy resin and a bifunctional phenol.

The circuit connecting material of the invention may further contain a filler, softening agent, accelerator, age inhibitor, coloring agent, flame retardant, thixotropic agent, coupling agent, phenol resin, melamine resin, isocyanate or the like.

Preferred coupling agents, from the viewpoint of adhesion, are compounds containing one or more groups selected from among vinyl, acrylic, amino, epoxy and isocyanate groups.

The circuit connecting material of the invention can provide connection by direct contact between opposing circuit electrodes during connection without including conductive particles, but more stable connection can be obtained if conductive particles are included.

Conductive particles include metallic particles such as Au, Ag, Ni, Cu or solder, and carbon particles. The surface of a transition metal such as Ni may also be coated with a precious metal such as Au. In order to achieve an adequate pot life (usable life), the surface layer is preferably not composed of a transition metal such as Ni or Cu, but rather of a precious metal such as Au, Ag or a platinum group metal, with Au being more preferred. In addition, preferably the conductive layer is formed on a non-conductive particle surface by a method such as coating the surfaces of non-conductive particles made of glass, ceramic, plastic or the like with the aforementioned conductive substance, and an outermost layer of a precious metal is further provided, or heat-fusible metallic particles are used, because this will allow deformability by hot pressing and will thereby increase the contact area between electrodes during connection and improve the reliability.

The conductive particle content may be appropriately selected depending on the purpose, but it will normally be in the range of 0.1-30 parts by volume with respect to 100 parts by volume of the adhesive resin component. From the viewpoint of preventing shorting between adjacent circuits by excess conductive particles, the content is more preferably 0.1-10 parts by volume.

Also, the pot life is improved if the circuit connecting material is divided into two or more layers including a layer containing a curing agent and a layer comprising conductive particles.

The connection structure of the invention and a method for producing it will now be explained.

Fig. 1 is a simplified cross-sectional view showing an embodiment of a connection structure. The connection structure 1 shown in Fig. 1 comprises a first circuit member 20 having a first circuit board 21 and a first circuit electrode (first connecting terminal) 22 formed on the main side 21a thereof, a second circuit member 30 having a second circuit board 31 and a second circuit electrode (second connecting terminal) 32 formed on the main side 31a thereof, and an adhesive layer 10 situated between and bonding the first circuit member 20 and second circuit member 30. The second circuit member 30 is laid facing the first circuit member 20 so that the second circuit electrode 32 opposes the first circuit electrode 22.

The adhesive layer 10 is formed by placing the circuit connecting material of the invention between the first circuit member 20 and second circuit member 30 and pressing them in that state. This embodiment is an example where a conductive circuit connecting material is used to form the adhesive layer 10, and the adhesive layer 10 comprises an insulating layer 11 and conductive particles 7 dispersed in the insulating layer 11. The insulating layer 11 is a cured body formed by radical polymerization of the radical polymerizing compound, in the components of the adhesive other than the conductive particles.

The opposing first circuit electrode 22 and second circuit electrode 32 are electrically connected via the conductive particles 7. The first circuit electrodes 22 and the second circuit electrodes 32 formed on the same circuit board are insulated from each other.

For the first circuit board 31 and second circuit board 21 there may be mentioned chip parts such as semiconductor chips, resistor chips and condenser chips, and boards such as printed boards. The circuit member will normally be provided with a plurality of connecting terminals, but it may have only one connecting terminal depending on the case.

More specifically, there may be used an inorganic material board made of a semiconductor, glass or ceramic, a plastic board, or a glass/epoxy board. As plastic boards there may be mentioned polyimide films, polycarbonate films and polyester films. The first circuit electrode and second circuit electrode are formed of a metal such as copper. For more satisfactory electrical connection, the surfaces of either or both the first circuit electrode and second circuit electrode are preferably a metal selected from among gold, silver, tin and platinum. The surface layer may be selected from among silver, platinum metals or tin, or combinations thereof. A plurality of metals such as copper/nickel/gold may also be combined in a multilayer structure.

Also, either the first circuit member 20 or second circuit member 30 may be a liquid crystal display panel having a glass panel or plastic panel as the circuit board and having connecting terminals formed from ITO or the like. In addition, either the first circuit member 20 or second circuit member 30 may be a flexible printed circuit board (FPC), tape carrier package (TCP) or chip-on-film (COF) having a polyimide film as the circuit board, or a semiconductor silicon chip having a semiconductor board as the circuit board. These circuit members may be appropriately combined as necessary to form the connection structure.

The board on which the circuit electrode has been formed is preferably subjected to pre-heating treatment before the step of connection to the circuit connecting material, in order to avoid the effects of the volatilizing components on connection due to heating for the connection.

The connection structure 1 is formed, for example, by superposing the first circuit member 20, film-like adhesive and second circuit member 30 in that order with the first connecting terminal 22 and second connecting terminal 32 opposing each other, and pressing them in that state, optionally with heating. The pressure is not particularly restricted so long as it is in a range that does not damage the adherend, and for most purposes it is preferably 0.1-10 MPa. The heating temperature is not particularly restricted but is preferably 100-250°C. The pressing and heating are preferably carried out for a period in a range of 0.5-120 seconds, and the bonding may include heating at 140-200°C, 3 MPa for 10 seconds.

### Examples

The present invention will now be explained in greater detail based on examples and comparative examples, with the understanding that these examples are in no way limitative on the invention.

### [Synthesis of 1,3,5-tris(3-mercaptobutyloxyethyl)-1,3,5-triazine-2,4,6(1H, 3H, 5H)-trione]

After charging 120 mmol (31.35 g) of 1,3,5-tris(2-hydroxyethyl)-1,3,5-triazine-2,4,6-(1H, 3H, 5H)-trione, 378 mmol (45.42 g) of 3-mercaptobutyric acid (Yodo Kagaku Co., Ltd.), 8.1 mmol (1.51 g) of p-toluenesulfonic acid monohydrate (Junsei Chemical Co., Ltd.) and 63 g of toluene in a 100 ml volumetric flask, a Dean-Stark apparatus and condenser tube were mounted. The contents were heated at an oil bath temperature of 140°C while stirring, for 4 hours of reaction. The mixture was then cooled and the reaction mixture was neutralized with 100 ml of a 10% sodium hydrogencarbonate aqueous solution. The reaction mixture was then rinsed 3 times with ion-exchanged water and subjected to dewatering and drying with anhydrous magnesium sulfate (Junsei Chemical Co., Ltd.). The toluene was distilled off to obtain 1,3,5-tris(3-mercaptobutyloxyethyl)-1,3,5-triazine-2,4,6(1H, 3H, 5H)-trione (a compound of formula (1) above comprising a thiol group). The obtained compound was a highly viscous colorless transparent liquid.

[Synthesis of pentaerythritol tetrakis(3-mercapto butyrate)] After charging 60 mmol (8.17 g) of 2,2-bis(hydroxymethyl) 1,2-propanediol (pentaerythritol, product of Koei Chemical Co., Ltd.), 252 mmol (30.28 g) of 3-mercaptobutyric acid (Yodo Kagaku Co., Ltd.), 5.2 mmol (0.98 g) of p-toluenesulfonic acid monohydrate (Junsei Chemical Co., Ltd.) and 40 g of toluene in a 100 ml volumetric flask, a Dean-Stark apparatus and condenser tube were mounted. The contents were heated at an oil bath temperature of 140°C while stirring, for 4 hours of reaction. The mixture was then cooled and the reaction mixture was neutralized with 100 ml of a 10% sodium hydrogencarbonate aqueous solution. The reaction mixture was then rinsed 3 times with ion-exchanged water and subjected to dewatering and drying with anhydrous magnesium sulfate (Junsei Chemical Co., Ltd.). The toluene was distilled off to obtain pentaerythritol tetrakis(3-mercapto butyrate) (a compound of formula (2) comprising a thiol group). The obtained compound was a highly viscous colorless transparent liquid.

### [Example 1]

There were combined 87.5 parts by weight of a 40 wt% solution obtained by dissolving bisphenol A/F copolymerizable phenoxy resin (ZX-1356-2 by Tohto Kasei Co., Ltd.) as a thermoplastic resin, in a toluene/ethyl acetate = 50/50 mixed solvent (35 parts by weight as solid content), 100 parts by weight of a 15 wt% solution obtained by dissolving a polyurethane resin (T-6075N by DIC Bayer Polymer, Ltd.) in methyl ethyl ketone (15 parts by weight as solid content), 25 parts by weight of a 20 wt% solution obtained by dissolving a styrene-maleic anhydride copolymer (D-250 by Nova Chemicals Japan, Ltd.) in toluene (5 parts by weight by solid content), 42.86 parts by weight of a 70 wt% solution of a urethane acrylate oligomer (UA5500T by Shin-Nakamura Chemical Corp.) in toluene (30 parts by weight as nonvolatile components) as a radical-polymerizing substance, 15 parts by weight of a dicyclopentadiene-type diacrylate (DCP-A by ToaGosei Co., Ltd.), 3 parts by weight of 2-methacryloyloxyethyl acid phosphate (P-2 M by Kyoeisha Chemical Co., Ltd.), 2 parts by weight of 1,3,5-tris(3-mercaptobutyloxyethyl)-1,3,5-triazine-2,4,6(1H, 3H, 5H)-trione (molecular weight: 567.7) as a compound containing secondary thiol group, 4 parts by weight of 2,5-dimethyl-2,5-di(2-ethylhexanoyl)hexane (PERHEXA 250 by NOF Corp.) as a free radical-generating curing agent (PERHEXA 250 is a 50% solution, with an actual 2,5-dimethyl-2,5-di(2-ethylhexanoyl)hexane content of 8 parts by weight), and 5 parts by weight of Ni powder with a mean particle size of 2-3.3 µm, having burr-shaped surface shapes. The mixed solution was coated onto a PET film with an applicator and hot air-dried at 70°C for 10 minutes to obtain a circuit connecting material having an adhesive layer with a thickness of 35 µm.

### [Example 2]

A circuit connecting material was obtained in the same manner as Example 1, except that 2 parts by weight of pentaerythritol tetrakis(3-mercaptobutyrate) (molecular weight: 544.77) was used instead of 1,3,5-tris(3-mercaptobutyloxyethyl)-1,3,5-triazine-2,4,6(1H, 3H, 5H)-trione.

### [Example 3]

A circuit connecting material was obtained in the same manner as Example 1, except that the amount of 1,3,5-tris(3-mercaptobutyloxyethyl)-1,3,5-triazine-2,4,6(1H, 3H, 5H)-trione (molecular weight: 567.7) used was 3 parts by weight.

### [Comparative Example 1]

A circuit connecting material was obtained in the same manner as Example 1, except that no compound containing secondary thiol group was used.

### [Comparative Example 2]

A circuit connecting material was obtained in the same manner as Example 1, except that 2 parts by weight of the primary thiol group-containing compound tris[(3-mercaptopropionyloxy)-ethyl] isocyanurate (TEMPIC, molecular weight: 525.62, product of Sakai Chemical Industry Co., Ltd.) was used instead of 1,3,5-tris(3-mercaptobutyloxyethyl)-1,3,5-triazine-2,4,6(1H, 3H, 5H)-trione.

### [Comparative Example 3]

A circuit connecting material was obtained in the same manner as Example 1, except that 2 parts by weight of the primary thiol group-containing compound pentaerythritoltetrakis(3-mercapto propionate) (PEMP, molecular weight: 488.66, product of Sakai Chemical Industry Co., Ltd.) was used instead of 1,3,5-tris(3-mercaptobutyloxyethyl)-1,3,5-triazine-2,4,6(1H, 3H, 5H)-trione.

### [Comparative Example 4]

A circuit connecting material was obtained in the same manner as Example 1, except that 2 parts by weight of the tertiary thiol group-containing compound ethyleneglycolbis(2-mercapto isobutyrate) (EGMIB, synthesized according to the synthesis method described in Japanese Unexamined Patent Publication No. 2004-149755, molecular weight: 266.38) was used instead of 1,3,5-tris(3-mercaptobutyloxyethyl)-1,3,5-triazine-2,4,6(1H, 3H, 5H)-trione.

### [Comparative Example 5]

A circuit connecting material was obtained in the same manner as Example 1, except that 2 parts by weight of the disulfide compound diphenyl disulfide (product of Sumitomo Seika Chemicals Co., Ltd., molecular weight: 218.34) was used instead of 1,3,5-tris(3-mercaptobutyloxyethyl)-1,3,5-triazine-2,4,6(1H, 3H, 5H)-trione.

### [Fabrication of connection structure (connection of COF and PWB)]

Each of the circuit connecting materials of Examples 1-3 and Comparative Examples 1-5 was used for connection between a flexible circuit board (COF-TEG) having a copper circuit with a line width of 100 µm, a pitch of 200 µm and a thickness of 8 µm formed directly on polyimide with a thickness of 38 µm, and a glass epoxy multilayer printed circuit board (PWB-TEG) having a copper circuit with a line width of 100 µm, a pitch of 200 µm and a thickness of 35 µm formed thereon, at 120°C-2 MPa-10 seconds, to a width of 2.0 mm. After attaching the adhesive side of the circuit connecting material onto the glass epoxy multilayer printed circuit board, the stack was hot pressed at 70°C, 1 MPa for 3 seconds for temporary connection and then the PET film was released and the COF-TEG was connected. The workability and handleability of each circuit connecting material in this step was evaluated based on the presence of odor. The results are shown in Table 1.

### [Measurement of bonding strength]

The bonding strength with 90° peeling for each prepared connection structure for a circuit member was measured at a peel rate of 50 mm/min. The measurement was carried out for the original circuit connecting material and the circuit connecting material after 5 days of treatment at 40°C. The results are shown in Table 1.

### [Measurement of connection resistance]

After connecting the circuit, the resistance value between the adjacent circuits of the FPC-PWB comprising this joint was measured with a multimeter, initially and after 5 days of treatment of the circuit connecting material at 40°C. The resistance value was the x+3σ value for 150 resistance points between the adjacent circuits. A satisfactory level of storage stability was considered to be 1.2-fold, as the increase in resistance after 5 days of treatment at 40°C with respect to the initial resistance. The results are shown in Table 1.

**[Table 1]**

| | Initial | | 40°C, 5 day treatment | | Workability/ Handleability (odor) |
|---|---|---|---|---|---|
| | Adhesive force (N/cm) | Resistance (Ω) | Adhesive force (N/cm) | Resistance (Ω) | |
| Example 1 | 8.5 | 0.19 | 8.4 | 0.20 | Good |
| Example 2 | 8.2 | 0.19 | 8.3 | 0.20 | Good |
| Example 3 | 8.3 | 0.19 | 8.4 | 0.20 | Good |
| Comp. Ex. 1 | 5.1 | 0.19 | 5.4 | 0.19 | Good |
| Comp. Ex. 2 | 8.9 | 0.19 | 9.1 | 0.25 | Good |
| Comp. Ex. 3 | 8.7 | 0.19 | 8.7 | 0.25 | Good |
| Comp. Ex. 4 | 5.6 | 0.19 | 5.7 | 0.20 | Poor |
| Comp. Ex. 5 | 5.8 | 0.19 | 5.8 | 0.20 | Poor |

As shown in Table 1, both the adhesive force and resistance were improved in Examples 1-3, both initially and after 5 days of treatment at 40°C. In Comparative Examples 1, 4 and 5, however, the adhesive force was reduced below the initial value. The low adhesive forces in Comparative Examples 4 and 5 were attributed to high steric hindrance of the tertiary thiol or diphenyl disulfide, resulting in lower reactivity as a chain transfer agent. In Comparative Examples 2 and 3, the increase in resistance value after 5 days of treatment at 40°C exceeded 1.2-ford, resulting in inferior storage stability.

## Claims

1. A circuit connecting material for connection between a first circuit member having a first circuit electrode formed on the main side of a first board, and a second circuit member having a second circuit electrode formed on the main side of a second board, with the first circuit electrode and second circuit electrode laid facing each other, the circuit connecting material comprising a curing agent that generates free radicals, a radical polymerizing substance and a compound containing a secondary thiol group.

2. A circuit connecting material according to claim 1, wherein the molecular weight of the compound containing a secondary thiol group is 400 or greater.

3. A connection structure comprising:
a first circuit member having a first circuit electrode formed on the main side of a first board,
a second circuit member having a second circuit electrode formed on the main side of a second board and situated so that the second circuit electrode and first circuit electrode are facing each other, and
an adhesive layer provided between the first circuit member and second circuit member and electrically connecting the first circuit member and second circuit member,
wherein the adhesive layer is formed by placing a circuit connecting material according to claim 1 or 2 between the first circuit member and second circuit member and pressing them.

4. A method for producing a connection structure, comprising a step of situating a first circuit member having a first circuit electrode formed on the main side of a first board and a second circuit member having a second circuit electrode formed on the main side of a second board, in such a manner that the first circuit electrode and second circuit electrode are facing each other, placing a circuit connecting material according to claim 1 or 2 between the first circuit member and second circuit member, and pressing them in that state for electrical connection between the first circuit electrode and second circuit electrode.
